# EUROPEAN PATENT APPLICATION

(11) **EP 3 696 850 A2**
(43) Date of publication of application: **19.08.2020**
(21) Application number: 20161804.8
(22) Date of filing: 12.09.2016
(51) Int. Cl.: H01L 23/495, H05K 3/34, B23K 35/26, C22C 13/02, B23K 35/02, B23K 35/362

(54) **METHOD OF SOLDERING AN ELECTRONIC COMPONENT TO A SUBSTRATE WITH THE USE OF A SOLDER PASTE COMPRISING A LEAD-FREE SOLDER ALLOY CONSISTING OF SN, BI AND AT LEAST ONE OF SB AND MN**

(62) Divisional of application: 16188368.1
(71) Applicant: Interflux Electronics N.V., 9042 Gent (BE)
(72) Inventor: Werkhoven, Daniel, 9042 GENT (BE); Peeters, Annick, 9042 GENT (BE); Lauwaert, Ralph, 9042 GENT (BE); Maris, Isabelle, 9042 GENT (BE); Van de Lisdonk, Bart, 9042 GENT (BE); Teliszewski, Steven, 9042 GENT (BE)
(74) Representative: Arnold & Siedsma

(57) **Abstract**

An electronic component package provided with an exposed die pad and a plurality of contact pads at least partially present on a bottom side thereof (for example, a quad-flat no lead (QFN) type package) is soldered to a substrate so that the contact pads and the die pad are soldered to associated contacts on the substrate by reflowing a solder paste composition comprising a lead-free solder alloy and a halide-free flux, the lead-free solder alloy having an alloy composition consisting of 58.0-62.0 wt% of tin (Sn), 38.0-41.0 wt% of bismuth (Bi) and either 0.01-1 wt% of manganese (Mn) or 0.01-2 wt.% of antimony (Sb) and 0-1.0 wt% of manganese (Mn), the lead-free solder alloy being free of nickel (Ni) and free of silver (Ag) and the solder alloy having a particle size in the range of 10-40 µm as defined by sieve analysis.

## Description

### Field of the invention

The invention relates to a lead free tin-bismuth solder composition.

The invention further relates to the use of such a lead-free tin-bismuth solder composition for soldering an electronic component package to a substrate, which electronic component package is provided with a plurality of contacts and an exposed die pad, which contacts and which die pads are soldered to associated contacts on the substrate.

### Background of the invention

Traditionally, solder compositions were based on eutectic lead-tin alloy, which has a melting point around 180°C. This composition was known to have good bonding properties. However, the use of this solder composition is no longer allowed due to the toxicity of lead. In the past twenty years, a tin-based solder has become the standard material for soldering in microelectronics. More particularly, this tin-based solder is an alloy of tin (Sn), silver (Ag) and copper (Cu), also known as SAC solder. Typically, the content of tin is over 95 wt%. One well-known alloy is the SAC305, with 3wt% Ag, 0.5% Cu and the balance being tin. A disadvantage of SAC solders is however the melting point that is typically in the range of 217-227 °C. The higher melting point requires that the reflow process (i.e. the operation wherein solder is melting and a connection is formed to the substrate) has to happen at a relatively high temperature, which increases the risk of failure due to thermal fatigue and the like.

An alternative type of solder is based on tin-bismuth (hereinafter also referred to as SnBi). Commercially available solder alloys based thereon include Sn42Bi58 and Sn42Bi57Ag1, wherein the numbers indicate the weight percentage of the respective element. These solder alloys are low melting, typically around 140°C, but more brittle when compared to SAC solder alloys. Investigations on tin-bismuth alloys were carried out in the early 1990s. Felton et al, 'The properties of tin-bismuth alloy solders', Journal of Minerals, Metals & Materials Society (JOM), 45(1993), 28-32, discloses ternary tin-bismuth alloys containing copper (Cu), zinc (Zn) or antimone (Sb) as ternary alloy element in an amount of 1.0wt%, both for Sn42Bi58 and an Sn60Bi40 alloy. On the basis of wetting areas of a test substrate, the authors observe that the average wetting areas for the Sn-Bi alloys are worse than those for the traditional Sn-Pb alloys. It is concluded that the ternary elements may give rise to coarsening during ageing, and therewith turn out to improve some of the mechanical behaviour of the solders. EP0629467 disclosed Sn-Bi alloys with 42-50wt% Sn, 46-56wt% Bi, and at least one of 1-2wt% Ag, 2-4wt% Cu and 1-2wt% In.

However, this development line appears to have been given up in favour of the SAC solders. One reason therefore is that bismuth is naturally a brittle element and the Sn-Bi solder alloy is also brittle. Even when the Bi-content of the Bi-alloy is decreased to less than 58%, it becomes brittle because Bi segregates in Sn. A solder joint soldered by using the Sn-Bi solder alloy may generate cracks because of its brittleness when any considerable stress is added thereto so that its mechanical strength may deteriorate. Further, in order to cope with the miniaturisation in electronics, a typical soldering area has decreased over time, and a narrower pitch between the solder pads must be used. As a consequence, less solder is used, which further increases the risk of deterioration of mechanical strength of Sn-Bi alloys. Japanese patent document no 2013-00744 discloses a Sn-Bi-Cu-Ni alloy. According to said patent document, this alloy has an improved mechanical strength because any intermetallic compounds having hexagonal closest packing structure are formed in the solder joined portion or on a solder joining interface. EP2987876A1 relates to an improved Sn-Bi-Cu-Ni alloy with 0.3-1.0 wt% Cu and 0.01-0.06wt% nickel (Ni) for use in combination with electroless Ni-Au plating on a solder pad. The electroless Ni-Au plated layer typically contains phosphorous (P). Upon heating, the Ni diffuses more quickly than the P. This leads, according to said patent document, to formation of a P-rich layer at the interface of the electroless nickel layer and the solder, which reduces mechanical strength. The addition of nickel to the alloy helps to suppress diffusion of Ni therein, and reduces the risk of formation of a separate P-rich layer. The solder alloy may further contain phosphorous (P) and/or germanium (Ge). Testing was done with solder balls containing the solder alloy and an aqueous flux. The 0.3 mm solder balls were placed on a board with copper pads with an electroless Ni-Au finish and were reflowed under a reflow profile with a peak temperature of 210°C.

However, electroless nickel-gold plating is not the only relevant finishing. Recently, alternative finishes are under investigation and in use that reduce costs relative to the electroless nickel-plating. Examples of such finishes are the immersion tin (Sn)-soldering and the Organic Solderability Preservative (OSP). It is desired to obtain a solder alloy that provides with the different finishes an appropriate reliability. Herein, it is observed that solder balls have a relative high height compared to other solder joints formed in other soldering methods, such as soldering with a solder paste and wave soldering. The resulting lower height of solder joints is more critical for reliability. In fact, field failures have been observed lately with solder chemistries that have passed standardized reliability tests.

### Summary of the invention

It is therefore an object of the invention to provide an improved solder alloy with a good reliability for use in a variety of soldering methods, such as wave soldering, reflow soldering, dip soldering, wire soldering, and selective soldering.
It is a further object of the invention to provide a soldering method with high reliability for electronic components with a relatively low stand-off height, i.e a low height of the solder connection.
It is again a further object of the invention to provide a soldering method for packaged electronic components having both contact pads and an exposed die pad. One example of such an electronic component package is the quad-flat non-leaded (QFN) package.

According to a first aspect, the invention relates to a lead-free solder alloy having an alloy composition comprising 21.0-49.0 wt% bismuth (Bi), 0.01-2 wt% of at least one further element chosen from the group of phosphorous (P), manganese (Mn), copper (Cu), zinc (Zn) and antimony (Sb), the balance being tin (Sn), the alloy composition being free of nickel (Ni). Preferably, the content of tin is 56.0-59.9wt% and the content of Bi is 38.0 to 42.0 wt%. More preferably, at least one further element is included. This element can be copper, manganese and antimony. Zinc and/or phosphorous may be present additionally.

According to a second aspect, the invention relates to a solder paste comprising a lead-free solder alloy and a solder flux, which solder alloy contains 21.0-49.0 wt% bismuth (Bi), 0.01-2 wt% of at least one further element chosen from the group of phosphorous (P), manganese (Mn), copper (Cu), zinc (Zn) and antimony (Sb), the balance being tin (Sn). Preferably, the content of tin is 56.0-59.9wt% and the content of Bi is 38.0 to 42.0 wt%. More preferably, the at least one further element contains one of copper, manganese and antimony. Zinc and/or phosphorous may be present additionally.

According to a further aspect, the invention relates more specifically to a lead-free solder alloy having an alloy composition containing 58.0-62.0wt% tin (Sn), 38.0-41.0 wt% bismuth (Bi), 0.05-0.5 wt% of copper (Cu) and being free of nickel (Ni). The invention further relates to a solder paste therewith.

According to another aspect, the invention relates more specifically to a lead-free solder alloy having an alloy composition comprising 58.0-62.0wt% tin (Sn), 38.0-41.0wt% bismuth and 0.01-2.0wt% antimony (Sb). Optionally any further elements of the group of phosphorous, manganese, copper and zinc may be present, more preferably manganese.

According to again a further aspect, the invention relates to the use of a solder paste comprising a lead free solder alloy and a solder flux for soldering an electronic component package to a substrate, which electronic component package is provided with a plurality of contacts and an exposed die pad, which contacts and which die pads are soldered to associated contacts on the substrate. Herein, the lead free solder alloy has an alloy composition containing 58.0-78.0wt% tin (Sn), 21.0-41.0 wt% bismuth (Bi), 0.01-2 wt% of at least one further element chosen from the group of phosphorous (P), manganese (Mn), copper (Cu), zinc (Zn) and antimony (Sb).

According to further aspects, the solder alloy of the invention is used in a solder bath, in a solder wire and/or for placement of surface mount devices (SMD) by means of a solder paste, such as passive components, for selective soldering and for pin-in-paste, so as to solder pins of packages into through-holes in the carrier.

The invention is based on the insight that the reliability of solder connections, particularly but not exclusively those with a low stand-off height and/or an exposed die pad, is significantly increased by reducing void formation. Voids may be formed in the soldered connection at various stages of lifetime of a soldered connection. One type of voids is for instance known as the Kirkendall voids, which have a submicron size and are located between the intermetallic compound formed during soldering and a copper land on a carrier. Kirkendall voids are caused by differences in interdiffusion rate of copper and tin, and can grow under influence of thermal aging and thermal cycling during use. Further types of voids are for instance macrovoids, microvoids and shrink hole voids. Macrovoids are formed by outgassing of the paste flux during reflow. The paste flux comprises organic compounds that are volatile at the reflow temperature, to generate organic vapours. If the organic vapours do not vacate the liquid solder prior to its solidification, they are trapped inside the solder connection, creating a void. Microvoids are found at the interface between the intermetallic compound and a copper land on a carrier, due to malperformance of the soldering process, including contaminations, roughness of the lands and a relatively cool reflow profile, for instance of 10-40 °C below a recommended reflow peak temperature. Shrink hole voids are caused by the shrinking of the bulk solder material during solidification.

It was found in investigations leading to the invention, that the use of specific tin-bismuth solder alloys turns out to reduce void formation. In comparative examples, it was observed that outgassing of the solder paste (during reflow) occurs more gradually for tin-bismuth alloys than for SAC-alloys. Further experiments showed that the void formation could be further optimized to levels well below 5% and even below 3%.

Preferably, the alloy was chosen so as to have a liquidus point below 200 °C and a solidus point in between of 130 and 150°C, for instance 135-143 °C. This was more particularly achieved if that the alloy was free of silver. For sake of clarity, the solidus and the liquidus point define the lower and the upper limits of a melting range, from entirely solid to entirely liquid. The melting point is therewith reduced in comparison to conventional SAC solders. Such reduction of reflow temperature is clearly advantageous for packages with an exposed die pad so as to prevent failure. The exposed die pad is comparatively big and thermally conductive. Heat is thus quickly transmitted, during reflow, to the encapsulated components, which however have a much lower coefficient of thermal expansion. The specific tin-bismuth solder alloys are not eutectic.

More particularly, the alloy is substantially free of nickel, such that the total amount of nickel is at most 5 ppm, and preferably less.

In a preferred embodiment, the alloy composition was a tin-bismuth solder containing 58.0-62.0wt% tin (Sn), 38.0-41.0 wt% bismuth (Bi), and at least one further element chosen from the group of phosphorous (P), manganese (Mn), antimony (Sb), copper (Cu) and zinc (Zn). More preferably, at least one of manganese, antimony and copper is present, while Zn and P may be additionally present. These class of alloys have a liquidus point of around 175 °C, allowing lowering of the reflow temperature to less than 200°C, or even to 180-190°C. The composition may contain some unavoidable impurities. As specified above, the silver content is suitably low, particularly less than 0.3wt%, preferably less than 0.1wt%. Most preferably, the composition is substantially free of silver.

Most preferred are tin-bismuth solders in which the further element is 0.05-0.5 wt% of copper (Cu), while the composition is free of free of nickel (Ni) and silver (Ag). The amount of copper is more preferably 0.05-0.25 wt%. These solders were found to have best performance with respect to void formation. Furthermore, it appears that these solders are best suitable for combination with substrates that are provided with a so called OSP finish. This refers to Organic Solderability Preservative. Such an OSP finish turns out less vulnerable for dust and other contaminations that often are present in assembly plants, particularly those located in East Asia.

Surprisingly good results have further been obtained with solder alloys, wherein the further element is antimony, and optionally manganese is present. Herein, it was observed that the oxidation of metal is significantly reduced compared to SAC solder and to lead-tin solder.

In accordance with preferred embodiments of the invention, the antimony content is - when present - in the range of 0.01-2.0% by weight. The manganese content is - when present - in the range of 0.01-1.0% by weight. The phosphorous content is - when present - in the range of 0.01-0.5% by weight. The zinc content is - when present - in the range of 0.1-1.0%. Preferably, at most two of the further elements are present, such as a combination of antimony and manganese. More preferably, the total content of any of the specified further elements is at most 2.0% by weight. In most preferred examples, the total content of further elements is at most 1.0% by weight. The solder alloy is suitably present in a solder paste composition that further comprises a flux with a particle size of 10-40 µm, more preferably 15-30 µm, such as 20-25 µm. This particle size is based upon sieving.

The lead-free solder alloy is suitably used in combination with a flux material that is halide-free. The solder flux typically contains an activator, a solvent and an organic foaming agent. Preferably, herein the activator is an organic acid, either a monoacid or a poly acid compound and more suitably an aliphatic acid, such as formic acid, acetic acid, citric acid, lactic acid, oxalic acid. The solvent is suitably a monohydric alcohol or an acetic ester or a mixture thereof. The monohydric alcohol is for instance a C₁-C₄ alkanol. More suitably, the solder flux may contain a rosin, a resin or be free thereof. Suitable resins are for instance polyesters. The solder alloy and the solder flux are suitably present in a volume ratio between 2:1 and 1:2, such as between 1.3:1 and 1:1.3, more preferably between 1.1:1 and 1:1.1.

While the use as a solder paste is particularly preferred, the solder alloy of the invention may alternatively be used in wave soldering, selective soldering, dip soldering , as part of a wire, for placement of SMDs and for pin-in-paste applications. The latter relates to the soldering of - typically discrete - components having a pin that is to be inserted into a through-hole of a carrier, such as a printed circuit board. The term 'selective soldering' more particularly refers to a process wherein a turbulent wave washes off flux. As a consequence, not the entire area of the substrate that has been sprayed with flux passes through the soldering process. A highly preferred application is the use of the solder paste for the soldering of packages with an exposed die pad, such as a QFN package.

As observed in further tests, the solder paste may be combined with a substrate having any time of finish, including an immersion tin finish, a nickel gold finish and an OSP copper finish.

The disclosure further comprises the following embodiments:
1. A lead-free solder alloy having an alloy composition containing 58.0-78.0wt% tin (Sn), 21.0-42.0 wt% bismuth (Bi), 0.01-2 wt% of at least one further element chosen from the group of phosphorous (P), manganese (Mn), copper (Cu), zinc (Zn) and antimony (Sb), and being at least substantially free of nickel (Ni).
2. The lead-free solder alloy of embodiment 1, wherein the at least one further element is chosen from
   - 0.05-0.5 wt % Cu
   - 0.01-1 wt% Mn, and
   - 0.01-2 wt% Sb.
3. The lead-free solder alloy of embodiment 2 substantially consisting of 58.0-62.0wt% tin (Sn), 38.0-41.0 wt% bismuth (Bi), 0.05-0.5 wt% of copper (Cu) and being free of nickel (Ni).
4. The lead-free solder alloy as embodied by embodiment 3, wherein the solder alloy comprises 0.05-0.25wt% Cu.
5. The lead-free solder alloy of embodiment 2, substantially consisting of 58.0-62.0wt% tin (Sn), 38.0-41.0 wt% bismuth (Bi), 0.01-2.0 wt% of antimony (Sb), 0-1.0% of manganese (Mn) and being free of nickel (Ni).
6. The lead-free solder alloy of any of the preceding embodiments, wherein the lead free solder alloy is at least substantially free of silver (Ag).
7. A solder composition comprising the lead-free solder alloy as embodied by any of the embodiments 1-6 and a halide-free solder flux.
8. The solder composition as embodied by embodiment 7, wherein the solder alloy has a particle size in the range of 10-40 µm as defined by sieve analysis, preferably 20-30µm.
9. The solder composition as embodied by embodiment 7 or 8, being a solder paste.
10. Use of a solder composition as embodied by any of the embodiments 7-9 for soldering an electronic component package to a substrate.
11. The use of the solder paste as embodied by embodiment 10, wherein the electronic component package is provided with a plurality of contacts and an exposed die pad, which contacts and which die pads are soldered to associated contacts on the substrate.
12. Use as embodied by embodiment 11, wherein the contacts are contact pads, which are at least partially present on a bottom side of the electric component package.
13. Use as embodied by embodiment 12, wherein the exposed die pad and the contact pads are arranged in a substantially co-planar way.
14. Use as embodied by any of the embodiments 10-13, wherein the electronic component package is a quad-flat no lead (QFN) type package.
15. Use as embodied by any of the embodiments 10-14, wherein the contact pads and any exposed die pad of the electronic component package are provided with a finish of the organic preservative type (OSP).

### Examples

In order to test reliability, void formation in so-called QFN packages was tested using X-ray analysis. The QFN-package is a package with an exposed die pad surrounded by a plurality of contact pads. The QFN package is a popular choice because of its thin and small profile, low weight and good thermal properties because of the exposed die pad and reduced lead inductance. It is similar to for instance QFP (quad flat package). In 2013, around 32.6 billion QFN packages have been assembled. Further variations on the QFN package are most likely to be developed. QFN packages typically comprise one or more integrated circuits. The plurality of contact pads is present at the four side edges of the package, typically extending both on a side face and the bottom face of the package. The number of contact pads is for instance in the range of 20-100. The pitch (heart-to-heart distance between neighbouring contact pads) is for instance in the range of 0.3-0.7 mm, and the width of the contact pad being about half of the pitch.

When performing X-ray analysis on soldered QFN packages (after reflow), excessive void formation can be observed under the exposed die pad of the QFN package, particularly with the SAC solders as commonly applied. A test carried out by applicant in investigations leading to the invention unexpectedly discovered that the void area can be more than 35% of the total area of the exposed die pad. Furthermore, it was found that the void formation can be different across a single substrate, typically a printed circuit board. This large void formation clearly has a negative impact on thermal conductivity, electric conductivity and mechanical strength of the assembled package.

Several lead-free solder alloys were tested. These are specified in Table 1.

**Table 1 - solder alloys (* = comparative example)**

| Nr | Sn (wt%) | Bi (wt%) | Ag (wt%) | Cu (wt%) | Sb (wt%) | Mn (wt%) |
|---|---|---|---|---|---|---|
| S1* | 96.5 | | 3.0 | 0.5 | | |
| S2* | 99 | | 0.3 | 0.7 | | |
| S3* | 96 | 3 | 0.3 | 0.7 | | |
| S4* | 80 | 20 | | | | |
| S5* | 42 | 57 | 1 | | | |
| S6 | 76.5 | 23 | | | 0.5 | |
| S7 | 70.5 | 28.5 | 0.65 | 0.35 | | |
| S8 | 68.2 | 31.5 | | 0.05 | 0.25 | |
| S9 | 59.9 | 40 | | 0.1 | | |
| S10 | 59.5 | 40 | | | 0.5 | |
| S11 | 59.9 | 40 | | | | 0.1 |
| S12 | 59.8 | 40 | | 0.1 | | 0.1 |

Solder pastes were prepared using Interflux® DP5600 solder flux in a mixture of 10wt% or 10.5 wt% flux and 89.5wt% or 90wt% solder alloy powder. This solder flux is specified for use in combination with low-melting Sn42Bi57Ag1 and Sn42Bi58 solder alloys. The solder paste is screen printed on testboard PCBs, using a MicroDEK 249 stencil printer, and a 120 µm stencil with no reduction. Printing solder paste without any reduction will give the worst voiding results, and was therefore chosen for comparison of different solder alloys. In each experiment, 3 QFN type components are placed on the test PCB. The test PCB has OSP-Cu finish. Use was made of packages supplied by Amkor® as MLF48 packages, with a size of 7 x 7 mm and an exposed die pad of 5x5 mm and 48 contact pads. After placing the packages on the test PCB, the PCBs are reflowed with an ERSA HotFlow 2/14 reflow oven.

Use was made of a standard linear reflow profile for lead-free soldering, with a peak temperature of 243°C. The standard linear reflow profile was adopted after initial experiments demonstrating that there was no major difference between a standard linear profile (with a peak at 235°C) and a soak profile (having a soak platform at 200°C and a peak at 250°C).

After reflow, the QFN components are inspected using an Y.Cougar FeinFocus X-Ray system for void analysis. Void analysis is performed via contrast detection and describes, when inspecting the soldered component for the topside, the surface area that has voided and the surface area without voiding.

Table 2 shows test results for the voiding

**Table 2; voiding results for compositions S1-S9**

| Nr | Lowest voiding | Median voiding | Highest voiding | Average | St Dev |
|---|---|---|---|---|---|
| S1* | 27.18% | 35.37% | 42.11% | 35.68% | 3.74% |
| S2* | 21.03% | 30.75% | 44.54% | 32.91% | 8.79% |
| S3* | 4.10% | 16.00% | 41.01% | 17.12% | 12.51% |
| S4* | 4.92% | 5.90% | 17.96% | 8.83% | 5.45% |
| S5* | 3.96% | 8.56% | 20.21% | 10.51% | 5.78% |
| S6 | 0.82% | 3.73% | 12.12% | 5.05% | 3.77% |
| S7 | 2.27% | 3.36% | 6.37% | 3.46% | 1.73% |
| S8 | 0.5% | 3.20% | 19.55% | 4.99% | 5.35% |
| S9 | 0.0% | 0.55% | 3.88% | 1.18% | 1.23% |

Further experiments were carried out with some further compositions. The test protocol was identical, except that the reflow temperature was chosen to have a peak temperature of 200°C. Table 3 shows the results.

**Table 3 : void test results obtained with solder alloys S10-11-12.**

| Nr | Lowest voiding | Median voiding | Highest voiding | Average | St Dev |
|---|---|---|---|---|---|
| S10 | 1.0% | 3.27% | 6.47% | 3.79% | 2.10% |
| S11 | 7.02% | 7.81% | 9.18% | 8.05% | 0.89% |
| S12 | 1.83% | 3.57% | 7.75% | 4.13% | 2.13% |

Further tests were carried out with the compositions S9. The compounds were subjected to two different standard reflow profiles, one for lead-free (243°C peak temperature) and one for leaded components (200°C). Furthermore the finish of the test board was varied, i.e. as OSP Copper (OSP Cu), Immersion Sn (Imm Sn) and NiAu, as known per se to the skilled person. Voiding results are shown in Table 4

**Table 4 - voiding results for alloy S9 with different finishings and at different peak temperatures.**

| Sample | Finish | Peak temperature | Lowest value | Median | Highest value | Average |
|---|---|---|---|---|---|---|
| S9 | OSP Cu | 243 °C | 1.5% | 1.8% | 3.9% | 2.5% |
| S9 | OSP Cu | 200 °C | 0.3% | 1.1% | 6.5% | 1.4% |
| S9 | NiAu | 243 °C | 0.0% | 0.15% | 1.0% | 0.3% |
| S9 | NiAu | 200 °C | 1.0% | 2.6% | 4.2% | 2.5% |
| S9 | Imm Sn | 200 °C | 0.2% | 1.1% | 5.2% | 1.7% |

## Claims

1. Method of soldering an electronic component package to a substrate, wherein the electronic component package is provided with a plurality of contact pads and an exposed die pad, which are at least partially present on a bottom side of the electronic component package, which contact pads and which die pad are soldered to associated contacts on the substrate by applying a solder paste composition comprising a lead-free solder alloy and a halide-free flux, wherein:
- the lead-free solder alloy has an alloy composition consisting of 58.0-62.0 wt% of tin (Sn), 38.0 to 41.0 wt% of bismuth (Bi), and either:
0.01-2 wt.% of antimony (Sb) and 0-1.0 wt.% manganese (Mn); or
0.01-1 wt% manganese (Mn),
- the lead-free solder alloy is free of nickel (Ni) and free of silver (Ag), and
- the solder alloy has a particle size in the range of 10-40µm as defined by sieve analysis.

2. Method of claim 1, wherein the component package is a quad-flat no lead (QFN) type package, wherein the QFN package has 20-100 contact pads with a pitch in the range of 0.3-0.7 mm and a contact pad width being half of the pitch.

3. Method of any of the preceding claims, wherein the amount of Sn is at most 59.9wt% of the alloy composition.

4. Method of claim 4, wherein the amount of Bi in the alloy composition is in the range of 40-41.0wt%.

5. Method of claim 1, wherein the applying the solder paste composition comprising the lead-free solder alloy and the halide-free flux comprises reflowing.

6. Method of claim 5, wherein the soldering reflow occurs at a reflow temperature of less than 200°C.

7. Method of claim 6, wherein the reflow temperature is in the range of 180-200°C.

8. Method of any of the preceding claims, wherein the contacts on the substrate are provided with a finish chosen from Organic Solderability Preservative (OSP), Immersion tin (Sn) and electroless nickel-gold (NiAu).

9. Method of claim 8, wherein the finish is OSP.

10. Method of any of the preceding claims, wherein the composition comprises 0.01-2 wt.% of antimony (Sb) and 0-1.0wt.% manganese (Mn).

11. Method of any of the preceding claims, wherein a total content of antimony and manganese is at most 2.0 wt.%, and preferably at most 1.0 wt%.

12. Method of any of the preceding claims, wherein the solder alloy and the solder flux are present in a volume ratio between 1.1:1 to 1:1.1.

13. Method of any of the preceding claims, wherein the exposed die pad and the contact pads are arranged in a substantially co-planar way.

14. Method of any one of the preceding claims, wherein the solder alloy the particle size is in the range of 20-30 µm
